# EUROPEAN PATENT APPLICATION

(11) **EP 4 779 340 A1**
(43) Date of publication of application: **22.07.2026**
(21) Application number: 25864576.1
(22) Date of filing: 26.09.2025
(51) Int. Cl.: G01R 31/392

(54) **BATTERY DIAGNOSIS DEVICE AND METHOD THEREFOR**

(30) Priority: 08.10.2024 KR 20240136293
(71) Applicant: LG ENERGY SOLUTION, LTD., Seoul 07335 (KR)
(72) Inventor: LEE, Hyun Chul, Yuseong-gu, Daejeon 34122 (KR)
(74) Representative: Plasseraud IP
(86) International application number: PCT/KR2025/015221
(87) International publication number: WO 2026/079762

(57) **Abstract**

A battery diagnosis device according to an embodiment of this document includes a memory in which one or more instructions are stored and a processor configured to execute the at least one instruction, in which the processor is configured to identify, based on the fact that rack states of health (SOHs) of the respective elements of a plurality of battery racks are identified, a minimum SOH corresponding to a minimum value among the rack SOHs and a maximum SOH corresponding to a maximum value among the rack SOHs, identify, based on a warranty SOH of a battery including the plurality of battery racks and an accuracy of the warranty SOH, a plurality of sections according to the SOH of the battery for expressing the SOH of the battery, and acquire, based on the fact that the minimum SOH is included in a specific section among the plurality of sections, the SOH of the battery using at least one of the minimum SOH, the maximum SOH, and any combination thereof.

## Description

### TECHNICAL FIELD

### Cross-reference to Related Applications

This application claims priority from Korean Patent Application No. 10-2024-0136293, filed on October 8, 2024, the disclosure of which is incorporated by reference herein.

### Technical Field

Embodiments disclosed in this document relate to a battery diagnosis device and battery diagnosis method.

### BACKGROUND ART

Recently, research and development on secondary batteries has been actively conducted. Here, secondary batteries are batteries that can be charged and discharged, and may be interpreted as including both conventional Ni/Cd batteries, Ni/MH batteries, and recent lithium-ion batteries. Recently, secondary batteries have been receiving attention as a next-generation energy storage medium, as their scope of use has expanded to include power sources for electric vehicles.

In a battery in which a plurality of battery racks (or battery packs) are connected in parallel, when expressing (or acquiring) an SOH of the battery, an average SOH of the plurality of battery racks or an SOH of each of the plurality battery racks is generally measured and the minimum value among the measured SOHs is used. In this case, there is a problem that the SOH of the battery cannot be accurately expressed when a special circumstance such as replacing the battery rack occurs.

Therefore, in order to solve the above problems, various studies are being conducted to accurately acquire and express the SOH of the battery.

### DISCLOSURE OF THE INVENTION

### TECHNICAL PROBLEM

Embodiments provide a battery diagnosis device and battery diagnosis method for acquiring an SOH of a battery by dividing a plurality of sections based on a warranty SOH and an accuracy of the warranty SOH.

Embodiments provide a battery diagnosis device and battery diagnosis method for acquiring the SOH of the battery according to a specific section in which the minimum SOH among rack SOHs of each of battery racks among a plurality of sections is included.

Embodiments provide a battery diagnosis device and battery diagnosis method for accurately acquiring the SOH of the battery even in a specific situation using the minimum SOH among the rack SOHs.

The technical problems of the present invention are not limited to the technical problems mentioned above, and other technical problems that are not mentioned may be clearly understood by those skilled in the art from the descriptions below.

### TECHNICAL SOLUTION

A battery diagnosis device according to an embodiment of this document includes a memory in which one or more instructions are stored and a processor configured to execute the at least one instruction, in which the processor is configured to identify, based on the fact that rack states of health (SOHs) of the respective elements of a plurality of battery racks are identified, a minimum SOH corresponding to a minimum value among the rack SOHs and a maximum SOH corresponding to a maximum value among the rack SOHs, identify, based on a warranty SOH of a battery including the plurality of battery racks and an accuracy of the warranty SOH, a plurality of sections according to the SOH of the battery for expressing the SOH of the battery, and acquire, based on the fact that the minimum SOH is included in a specific section among the plurality of sections, the SOH of the battery using at least one of the minimum SOH, the maximum SOH, and any combination thereof.

In an embodiment, the processor may be configured to acquire the SOH of the battery using the maximum SOH based on the fact that the minimum SOH is included in a first section including a largest representative value among representative values respectively included in the plurality of sections among the plurality of sections.

In an embodiment, the processor may be configured to acquire the SOH of the battery using the minimum SOH based on the fact that the minimum SOH is included in a second section including a smallest representative value among representative values respectively included in the plurality of sections among the plurality of sections.

In an embodiment, the plurality of sections may include a first section including a largest representative value among representative values respectively included in the plurality of sections, and a second section including a smallest representative value among the representative values, and the processor may be configured to acquire the SOH of the battery using at least one of the minimum SOH, the maximum SOH, a weight, and any combination thereof, based on the fact that the minimum SOH is included in a third section different from both the first section and the second section.

In an embodiment, the processor may be configured to divide the third section into at least one sub-section based on at least one of the minimum SOH, the maximum SOH, the weight, and any combination thereof.

In an embodiment, the processor may be configured to acquire the weight based on at least one of the warranty SOH, the accuracy, and any combination thereof.

In an embodiment, the plurality of sections may be divided into an odd number of sections.

In an embodiment, the warranty SOH may include a smallest usable SOH of the battery.

A battery diagnosis method according to an embodiment of this document includes an operation of identifying, by a processor, based on the fact that rack states of health (SOHs) of the respective elements of a plurality of battery racks are identified, a minimum SOH corresponding to a minimum value among the rack SOHs and a maximum SOH corresponding to a maximum value among the rack SOHs, an operation of identifying, by the processor, based on a warranty SOH of a battery including the plurality of battery racks and an accuracy of the warranty SOH, a plurality of sections according to the SOH of the battery for expressing the SOH of the battery, and an operation of acquiring, by the processor, based on the fact that the minimum SOH is included in a specific section among the plurality of sections, the SOH of the battery using at least one of the minimum SOH, the maximum SOH, and any combination thereof.

The battery diagnosis method according to an embodiment may include an operation of acquiring, by the processor, the SOH of the battery using the maximum SOH based on the fact that the minimum SOH is included in a first section including a largest representative value among representative values respectively included in the plurality of sections among the plurality of sections.

The battery diagnosis method according to an embodiment may include an operation of acquiring, by the processor, the SOH of the battery using the minimum SOH based on the fact that the minimum SOH is included in a second section including a smallest representative value among representative values respectively included in the plurality of sections among the plurality of sections.

In an embodiment, the plurality of sections may include a first section including a largest representative value among representative values respectively included in the plurality of sections, and a second section including a smallest representative value among the representative values, and the battery diagnosis method may include an operation of acquiring, by the processor, the SOH of the battery using at least one of the minimum SOH, the maximum SOH, a weight, and any combination thereof, based on the fact that the minimum SOH is included in a third section different from both the first section and the second section.

The battery diagnosis method according to an embodiment may include an operation of dividing, by the processor, the third section into at least one sub-section based on at least one of the minimum SOH, the maximum SOH, the weight, and any combination thereof.

The battery diagnosis method according to an embodiment may include an operation of acquiring, by the processor, the weight based on at least one of the warranty SOH, the accuracy, and any combination thereof.

In an embodiment, the plurality of sections may be divided into an odd number of sections.

### ADVANTAGEOUS EFFECTS

The present technology can acquire the SOH of the battery by dividing the plurality of sections based on the warranty SOH and the accuracy of the warranty SOH.

In addition, the present technology can acquire the SOH of the battery according to a specific section in which the minimum SOH among SOHs of each of battery racks among the plurality of sections is included.

In addition, the present technology can accurately acquire the SOH of the battery even in a specific situation using the minimum SOH among the rack SOHs.

In addition, various effects that are directly or indirectly identified through this document can be provided.

### BRIEF DESCRIPTION OF THE DRAWINGS

FIG. 1 is a block diagram showing a battery pack, in a battery diagnosis device and battery diagnosis method according to an embodiment of this document
FIG. 2 illustrates an example of a block diagram illustrating a configuration of a battery diagnosis device according to an embodiment of this document.
FIG. 3 illustrates an example of a table related to a plurality of sections and SOH for each section in an embodiment of this document.
FIG. 4 illustrates an example of a table related to a plurality of sections and SOH for each section in an embodiment of this document.
FIG. 5 illustrates an example of a graph related to SOH of a battery in an embodiment of this document.
FIG. 6 illustrates an example of a flowchart related to a battery diagnosis method according to an embodiment of this document.
FIG. 7 is a block diagram illustrating a hardware configuration of a computing system that performs a battery diagnosis method, in a battery diagnosis device and the battery diagnosis method according to an embodiment of this document.

### MODE FOR CARRYING OUT THE INVENTION

Hereinafter, some embodiments described in this document are described with reference to the accompanying drawings. However, this is not intended to limit the present technology to a specific embodiment, but should be understood to include various modifications, equivalents, and/or alternatives of the embodiments of the present technology.

When adding reference numerals to components in each drawing, it should be noted that the same components are given the same reference numerals as much as possible even if they are shown in different drawings. In addition, when describing various embodiments disclosed in this document, if a specific description of a related known configuration or function is determined to hinder understanding of the embodiments of the present disclosure, the detailed description thereof is omitted. A singular form of a noun corresponding to an item may include one item or a plurality of items unless the relevant context clearly indicates otherwise.

In describing the components of the embodiments of this document, terms such as first, second, A, B, (a), (b), etc. may be used. These terms are only intended to distinguish the components from other components, and the nature, order, or sequence of the components are not limited by the terms. In addition, unless otherwise defined, all terms used herein, including technical or scientific terms, have the same meaning as generally understood by a person having ordinary skill in the art to which the embodiments disclosed in this document belong. Terms defined in commonly used dictionaries should be interpreted as having a meaning consistent with the meaning they have in the context of the relevant technology, and shall not be interpreted in an ideal or excessively formal sense unless explicitly defined in this application.

In addition, in the present disclosure, expressions of "more than" or "less than" may be used to determine whether a specific condition is satisfied or fulfilled, but this is only a description for expressing an example and does not exclude descriptions of "greater than or equal to" or "less than or equal to". A condition described as "greater than or equal to" may be replaced with "more than", a condition described as "less than or equal to" may be replaced with "less than", and a condition described as "greater than or equal to and less than" may be replaced with "more than and less than or equal to". In addition, hereinafter, "A" to "B" mean at least one of the elements from A (including A) to B (including B).

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

According to an embodiment, the method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store, distributed directly between two user devices, or distributed online (e.g., downloaded or uploaded). In the case of online distribution, at least a part of the computer program product may be temporarily stored or temporarily generated in a machine-readable recording medium, such as a memory of a manufacturer's server, an application store's server, or a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by adding one or more other operations.

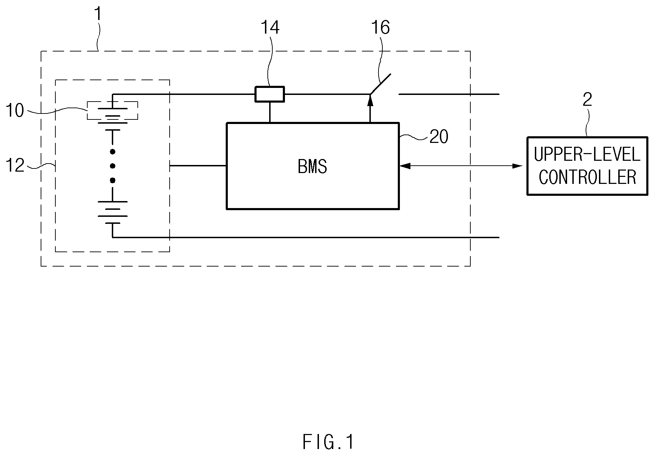

Hereinafter, embodiments of this document will be described in detail with reference to FIGS. 1 to 7.

FIG. 1 is a block diagram showing a battery pack, in a battery diagnosis device and battery diagnosis method according to an embodiment of this document.

Referring to FIG. 1, a battery pack 1 may include a battery unit 12, a sensor unit 14, a switching unit 16, and a battery management system (BMS) 20. In this case, the battery pack 1 may be equipped with a plurality of battery units 12, sensor units 14, switching units 16, and battery management systems 20.

According to an embodiment, the battery unit 12 may supply power to a target device (not shown). To this end, the battery unit 12 may be electrically connected to the target device. Here, the target device may include an electrical, electronic, or mechanical device that operates by receiving power from the battery pack 1. For example, the target device may be, but is not limited to, an electric vehicle (EV).

According to an embodiment, the battery unit 12 may include at least one battery cell 10 that is chargeable and dischargeable. Here, the battery cell 10 may be a basic unit of a battery cell that can be used by charging and discharging electric energy. For example, the battery cell 10 may be a lithium-ion (Li-ion) battery, a lithium-ion polymer battery, a nickel-cadmium (Ni-Cd) battery, a nickel-metal hydride (Ni-MH) battery, etc., but is not limited thereto.

According to an embodiment, a plurality of battery units 12 may be connected in series or in parallel. For example, the battery unit 12 may be a battery module, a battery bank, or a set of battery cells (cell-to-pack structure).

According to an embodiment, the sensor unit 14 may acquire information related to the battery unit 12. According to an embodiment, the sensor unit 14 may acquire values (or information) related to a state of each of the battery units 12 or battery cells 10. In an embodiment, the values related to the state may include one or more values for a voltage, a current, a resistance, a state of charge (SOC), a state of health (SOH), or a temperature of the battery cell, or a combination thereof.

According to an embodiment, the sensor unit 14 may provide information on each of the plurality of battery units 12 to the battery management system 20.

According to an embodiment, the switching unit 16 may include a device for controlling a current flow for charging or discharging the battery unit 12. For example, the switching unit 16 may include at least one relay and/or magnetic contactor, etc., depending on the specifications of the battery pack 1.

According to an embodiment, the battery management system (BMS) 20 may control or manage the battery pack 1 to prevent overcharging and overdischarging, etc. by monitoring the voltage, current, temperature, etc. of the battery pack 1. For example, the battery management system 20 is an interface that receives values acquired by measuring various parameters described above, and may include a plurality of terminals, a circuit connected to these terminals to process the received values, etc. In addition, the battery management system 20 may control the sensor unit 14 and/or the switching unit 16. For example, the battery management system 20 may be connected to a plurality of battery units 12 to monitor the state of each of the plurality of battery units 12 and control ON/OFF of a relay or contactor, etc.

According to an embodiment, an operation of the battery management system 20 may be performed by a battery management system (BMS) in a vehicle, and may also be performed in various devices such as a server, a cloud, a charger, or a discharger.

An upper-level controller 2 may transmit a control signal for the plurality of battery units 12 to the battery management system 20. Accordingly, the operation of the battery management system 20 may be controlled based on a signal applied from the upper-level controller 2.

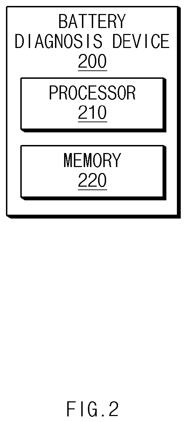

According to an embodiment, the battery management system 20 may include a battery diagnosis device 200 of FIG. 2. According to another embodiment, the battery management system 20 may be a different system from the battery diagnosis device 200 of FIG. 2. That is, the battery diagnosis device 200 of FIG. 2 may be included in the battery pack 1 or may be configured as another device external to the battery pack 1. Hereinafter, for convenience of description, the description will be made on the assumption that the battery diagnosis device 200 is configured as another device external to the battery pack 1. In addition, the operation of the battery diagnosis device 200 described below may be performed by a BMS in the vehicle, and may also be performed by various devices such as a server, a cloud, a charger, or a discharger.

FIG. 2 illustrates an example of a block diagram illustrating a configuration of a battery diagnosis device according to an embodiment of this document.

Referring to FIG. 2, the battery diagnosis device 200 according to an embodiment may include a processor 210 and a memory 220. The processor 210 and the memory 220 may be electrically and/or operably coupled with each other by an electronic component including a communication bus.

Hereinafter, operably coupling pieces of hardware with each other may include a direct connection and/or an indirect connection between pieces of hardware being established in a wired manner and/or wirelessly, such that a second piece of hardware is controlled by a first piece of hardware among the pieces of hardware.

Although pieces of hardware are illustrated in different blocks, embodiments are not limited thereto. For example, some of the pieces of hardware of FIG. 2 may be included in a single integrated circuit including a system on a chip (SoC). The type and/or number of pieces of hardware included in the battery diagnosis device 200 is not limited to that shown in FIG. 2. For example, the battery diagnosis device 200 may include only some pieces of the hardware shown in FIG. 2.

The battery diagnosis device 200 according to an embodiment may include hardware for processing data based on one or more instructions. The hardware for processing data may include the processor 210.

For example, hardware for processing data may include an arithmetic and logic unit (ALU), a floating point unit (FPU), a field programmable gate array (FPGA), a central processing unit (CPU), and/or an application processor (AP). The processor 210 may have a single-core processor architecture or a multi-core processor architecture having dual cores, quad cores, hexa cores, or octa cores.

The memory 220 of the battery diagnosis device 200 according to an embodiment may include hardware components for storing data and/or instructions input and/or output to and from the processor 210 of the battery diagnosis device 200.

For example, the memory 220 may include a volatile memory including a random-access memory (RAM) and/or a non-volatile memory including a read-only memory (ROM).

For example, the volatile memory may include at least one of dynamic RAM (DRAM), static RAM (SRAM), cache RAM, pseudo SRAM (PSRAM), and any combination thereof.

For example, the non-volatile memory may include at least one of a programmable ROM (PROM), an erasable PROM (EPROM), an electrically erasable PROM (EEPROM), a flash memory, a hard disk, a compact disc, a solid state drive (SSD), an embedded multi-media card (eMMC), and any combination thereof.

For example, at least one instruction (or command) indicating operations and/or actions to be performed on data by the processor 210 of the battery diagnosis device 200 may be stored in the memory 220 of the battery diagnosis device 200. A set of one or more instructions may be referred to as a program, firmware, operating system, process, routine, subroutine, and/or application. Hereinafter, the installation of an application in the battery diagnosis device 200 may mean that at least one instruction provided in the form of an application is stored in the memory 220, and that the application is stored in an executable format (e.g., a file having an extension designated by an operating system of the battery diagnosis device 200) by the processor 210 of the battery diagnosis device 200.

The processor 210 of the battery diagnosis device 200 according to an embodiment may identify a rack state of health (SOH) of each of the plurality of battery racks. For example, the processor 210 may identify at least one of a maximum SOH corresponding to a maximum value among the rack SOHs, and any combination thereof, a minimum state of health (SOH) corresponding to a minimum value among the rack SOHs, based on the fact that rack states of health (SOHs) of each of a plurality of battery racks are identified. For example, the processor 210 may identify the minimum state of health (SOH) corresponding to the minimum value among the rack SOHs and the maximum SOH corresponding to the maximum value among the rack SOHs, based on the fact that rack states of health (SOHs) of each of a plurality of battery racks are identified. For example, the rack SOH may mean the SOH of the battery rack.

In an embodiment, the processor 210 may identify at least one of a warranty SOH of a battery including a plurality of battery racks, an accuracy of the warranty SOH, and any combination thereof. For example, the processor 210 may identify a plurality of sections according to the SOH of the battery for expressing the SOH of the battery, based on the warranty SOH of the battery including the plurality of battery racks and the accuracy of the warranty SOH.

For example, the warranty SOH may include a smallest usable SOH of the battery.

In an embodiment, the processor 210 may identify which of the plurality of sections the minimum SOH corresponding to the minimum value among the rack SOHs is included. For example, the processor 210 may express the SOH of the battery according to a section in which the minimum SOH is included. For example, the processor 210 may express the SOH of a battery acquired using at least one of the minimum SOH, the maximum SOH, and any combination thereof.

For example, the plurality of sections may include at least one of a first section including a largest representative value among the representative values respectively included in the plurality of sections, a second section including a smallest representative value among the representative values, and any combination thereof. For example, the plurality of sections may include at least one of the first section including a largest representative value among the representative values respectively included in the plurality of sections, the second section including the smallest representative value among the representative values, and a third section different from the first section and the second section, and any combination thereof. For example, the plurality of sections may be divided into an odd number of sections. For example, the plurality of sections may be divided into (2n + 1) sections, where n may include a natural number.

For example, the representative value may include at least one of an average value, a median value, a mode value, a maximum value, a minimum value, and any combination thereof.

For example, the processor 210 may acquire the SOH of the battery using the maximum SOH based on the fact that the minimum SOH is included in the first section including the largest representative value among representative values respectively included in the plurality of sections among the plurality of sections. For example, the processor 210 may express the SOH of the battery acquired using the maximum SOH based on the fact that the minimum SOH is included in the first section.

For example, the processor 210 may acquire the SOH of the battery using the minimum SOH based on the fact that the minimum SOH is included in the second section including the smallest representative value among the representative values respectively included in the plurality of sections among the plurality of sections. For example, the processor 210 may express the SOH of the battery acquired using the minimum SOH based on the fact that minimum SOH is included in the second section.

For example, the processor 210 may identify whether the minimum SOH is included in a third section different from both the first section and the second section. For example, the processor 210 may acquire the SOH of the battery using at least one of the minimum SOH, the maximum SOH, a weight, and any combination thereof, based on the fact that the minimum SOH is included in the third section different from both the first section and the second section. For example, the processor 210 may express the SOH of the battery acquired using at least one of the minimum SOH, the maximum SOH, a weight, and any combination thereof, based on the fact that the minimum SOH is included in the third section different from both the first section and the second section.

For example, the processor 210 may acquire the weight based on at least one of the warranty SOH, an accuracy thereof, and any combination thereof. For example, the processor 210 may acquire the weight from a mapping table stored in the memory 220 based on at least one of the warranty SOH, the accuracy, and any combination thereof.

For example, the processor 210 may divide the third section into at least one sub-section based on at least one of the minimum SOH, the maximum SOH, the weight, and any combination thereof. For example, the processor 210 may divide the third section into one or more sub-sections based on at least one of the minimum SOH, the maximum SOH, the weight, and any combination thereof.

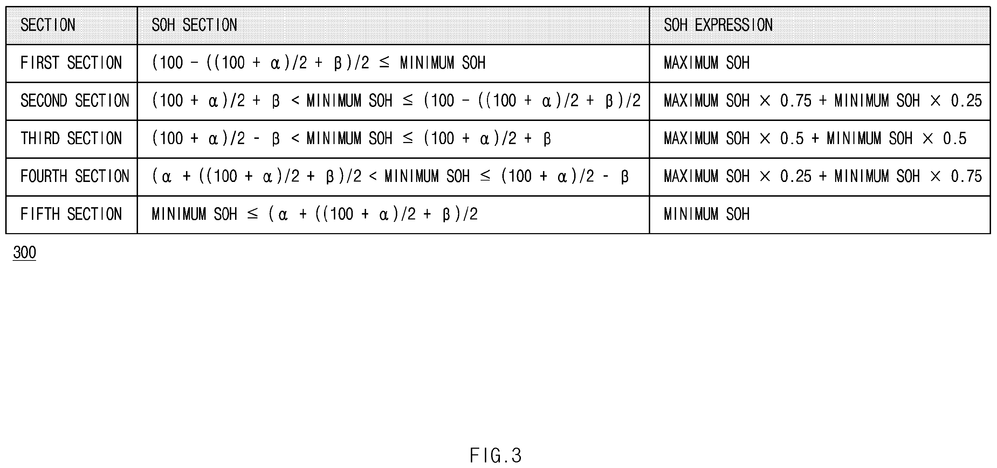

Descriptions related to the first section, the second section, and the third section will be described below with reference to FIGS. 3 to 5.

As described above, the battery diagnosis device 200 according to an embodiment may acquire the SOH of the battery according to the section in which the minimum SOH corresponding to a smallest value among the rack SOHs of each of the battery racks is included. The battery diagnosis device 200 may accurately acquire the SOH of the battery by acquiring the SOH of the battery using the process described above.

FIG. 3 illustrates an example of a table related to a plurality of sections and SOH for each section in an embodiment of this document.

A table 300 of FIG. 3 may be an expression of a plurality of sections (e.g., SOH sections) and a method of expressing SOH in each section using a general formula.

The table 300 of FIG. 3 may include a plurality of sections divided into a first section to a fifth section.

In the table 300, α may mean a warranty SOH. In Table 300, β may mean an accuracy.

Referring to the table 300, the first section may include a section in which the minimum SOH is greater than or equal to (100 - ((100 + α)/2 + β)/2). The second section may include a section in which the minimum SOH exceeds ((100 + α)/2 + β) and is less than or equal to (100 - ((100 + α)/2 + β)/2). The third section may include a section in which the minimum SOH exceeds ((100 + α) /2 - β) and is less than or equal to ((100 + α)/2 + β). The fourth section may include a section in which the minimum SOH exceeds (α + ((100 + α)/2 + β)/2) and is less than or equal to ((100 + α) /2 - β). The fifth section may include a section in which the minimum SOH is less than or equal to {α + ((100 + α)/2 + β)/2).

For example, the second section to fourth section may be included in the third section described in FIG. 2. For example, the second to fourth sections may be included in the sub-sections obtained by dividing the third section described in FIG. 2.

In each section, the processor 210 of the battery diagnosis device 200 may express the SOH of the battery.

For example, when the minimum SOH is included in the first section, the processor 210 may express the SOH of the battery using the maximum SOH.

For example, when the minimum SOH is included in the second section, the processor 210 may express the SOH of the battery based on applying a first weight (e.g., 0.75) to the maximum SOH and applying a second weight (e.g., 0.25) to the minimum SOH. For example, the processor 210 may express the SOH of the battery using the sum of the maximum SOH to which the first weight is applied and the minimum SOH to which the second weight is applied.

For example, when the minimum SOH is included in the third section, the processor 210 may express the SOH of the battery based on applying a third weight (e.g., 0.5) to the maximum SOH and applying the third weight to the minimum SOH. For example, the processor 210 may express the SOH of the battery using the sum of the maximum SOH to which the third weight is applied and the minimum SOH to which the third weight is applied.

For example, when the minimum SOH is included in the fourth section, the processor 210 may express the SOH of the battery based on applying the second weight to the maximum SOH and applying the first weight to the minimum SOH. For example, the processor 210 may express the SOH of the battery using the sum of the maximum SOH to which the second weight is applied and the minimum SOH to which the first weight is applied.

For example, when the minimum SOH is included in the fifth section, the processor 210 may express the SOH of the battery using the minimum SOH.

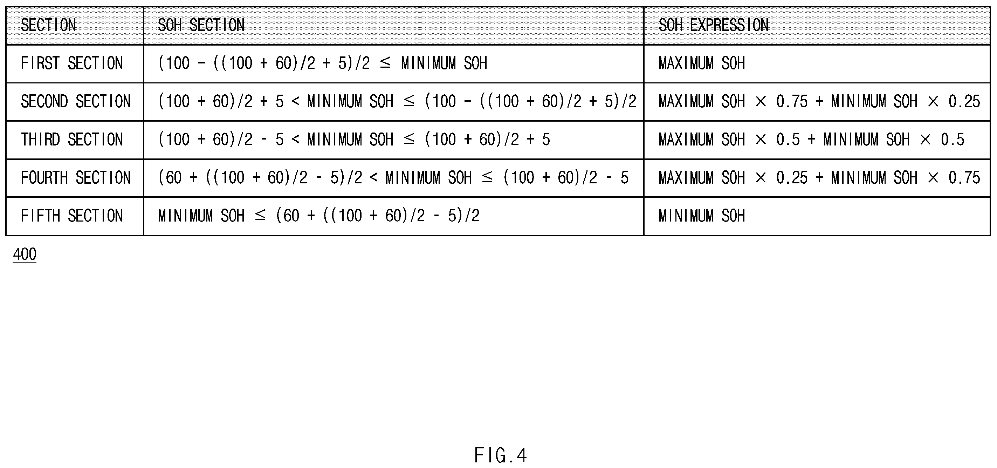

FIG. 4 illustrates an example of a table related to a plurality of sections and an SOH for each section in an embodiment of this document.

A table 400 of FIG. 4 may include an example of each section and a method of expressing the SOH for each section when the warranty SOH of the battery is 60% and the accuracy is +/- 5%. However, the embodiments of this document are not limited thereto.

Referring to the table 400, a first section may include a section in which the minimum SOH is greater than or equal to (100 - ((100 + 60)/2 + 5)/2). A second section may include a section in which the minimum SOH exceeds ((100 + 60)/2 + β) and is less than or equal to (100 - ((100 + 60)/2 + β)/2). A third section may include a section in which the minimum SOH exceeds ((100 + 60)/2 - 5) and is less than or equal to ((100 + 60)/2 + 5). A fourth section may include a section in which the minimum SOH exceeds (60 + ((100 + 60)/2 + 5) /2) and is less than or equal to ((100 + 60) /2 - 5). A fifth section may include a section in which the minimum SOH is less than or equal to (60 + ((100 + 60)/2 + 5)/2).

For example, the first section may include a section in which the minimum SOH is 92.5% or more. For example, the second section may include a section in which the minimum SOH exceeds 85% and less than or equal to 92.5%. For example, the third section may include a section in which the minimum SOH exceeds 75% and is less than or equal to 85%. For example, the fourth section may include a section in which the minimum SOH exceeds 67.5% and is less than or equal to 75%. For example, the fifth section may include a section in which the minimum SOH is 67.5% or less.

In each section, the processor 210 of the battery diagnosis device 200 may express the SOH of the battery.

For example, when the minimum SOH is included in the first section, the processor 210 may express the SOH of the battery using the maximum SOH.

For example, when the minimum SOH is included in the second section, the processor 210 may express the SOH of the battery based on applying a first weight (e.g., 0.75) to the maximum SOH and applying a second weight (e.g., 0.25) to the minimum SOH. For example, the processor 210 may express the SOH of the battery using the sum of the maximum SOH to which the first weight is applied and the minimum SOH to which the second weight is applied.

For example, when the minimum SOH is included in the third section, the processor 210 may express the SOH of the battery based on applying a third weight (e.g., 0.5) to the maximum SOH and applying the third weight to the minimum SOH. For example, the processor 210 may express the SOH of the battery using the sum of the maximum SOH to which the third weight is applied and the minimum SOH to which the third weight is applied.

For example, when the minimum SOH is included in the fourth section, the processor 210 may express the SOH of the battery based on applying the second weight to the maximum SOH and applying the first weight to the minimum SOH. For example, the processor 210 may express the SOH of the battery using the sum of the maximum SOH to which the second weight is applied and the minimum SOH to which the first weight is applied.

For example, when the minimum SOH is included in the fifth section, the processor 210 may express the SOH of the battery using the minimum SOH.

For example, when the minimum SOH is 73% and the maximum SOH is 80%, the processor 210 of the battery diagnosis device 200 may multiply the maximum SOH by 0.25 and the minimum SOH by 0.75, and then express the sum of the two, that is, 74.75%, as the SOH of the battery.

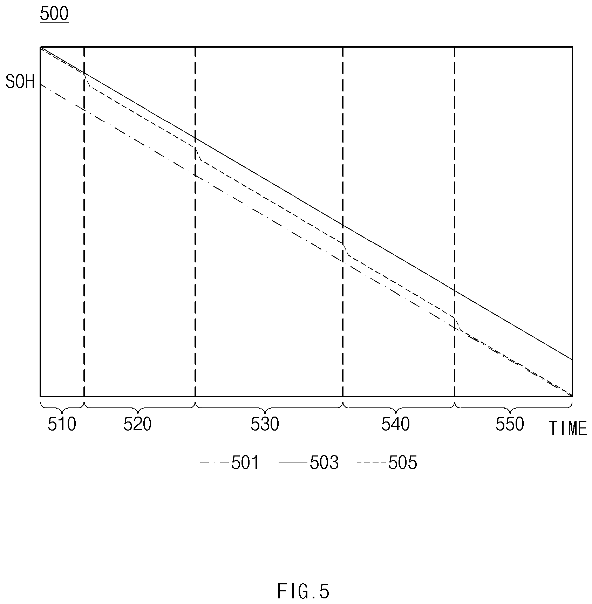

FIG. 5 illustrates an example of a graph related to SOH of a battery in an embodiment of this document.

Referring to FIG. 5, an example in which the processor 210 of the battery diagnosis device 200 according to an embodiment expresses a minimum SOH 501, a maximum SOH 503, and an SOH 505 of a battery according to each section.

The horizontal axis of the graph 500 of FIG. 5 may represent time, and the vertical axis may represent the SOH of the battery. For convenience of description, each section is divided and expressed based on the horizontal axis, but each section may be acquired by being divided by the warranty SOH and the accuracy of the warranty SOH.

For example, the processor 210 of the battery diagnosis device 200 may identify a plurality of sections 510, 520, 530, 540, and 550 according to the SOH 505 of the battery based on the warranty SOH of the battery and the accuracy of the warranty SOH.

For example, the first section 510 may be a section that includes the largest representative value among the representative values respectively included in the plurality of sections. For example, the fifth section 550 may be a section that includes the smallest representative value among the representative values respectively included in the plurality of sections. For example, the second section 520 to the fourth section 540 may be included in at least one sub-section included in the third section described in FIG. 2. For example, the second section 520 to the fourth section 540 may be sections different from both the first section 510 and the fifth section 550.

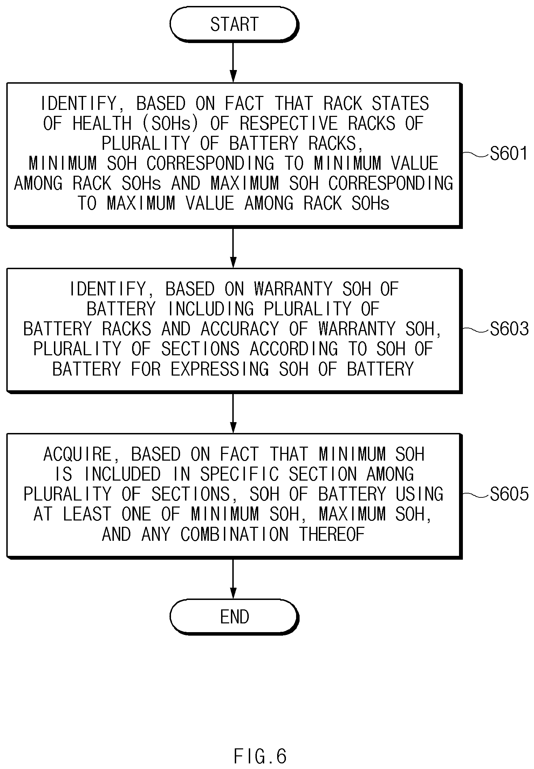

FIG. 6 illustrates an example of a flowchart related to a battery diagnosis method according to an embodiment of this document.

Hereinafter, it is assumed that the battery diagnosis device 200 of FIG. 2 performs the process of FIG. 6. In addition, in the description of FIG. 6, it may be understood that the operation described as being performed by the device is controlled by the processor 210 of the battery diagnosis device 200.

At least one of the operations of FIG. 6 may be performed by the battery diagnosis device 200 of FIG. 2. At least one of the operations of FIG. 6 may be controlled by the processor 210 of FIG. 2. Each of the operations of FIG. 6 may be performed sequentially, but they are not necessarily performed sequentially. For example, the order of each of the operations may be changed, and at least two operations may be performed in parallel.

Referring to FIG. 6, in operation S601, a battery diagnosis method according to an embodiment may include an operation of identifying, based on the fact that rack states of health (SOHs) of the respective elements of a plurality of battery racks are identified, a minimum SOH corresponding to a minimum value among the rack SOHs and a maximum SOH corresponding to a maximum value among the rack SOHs.

In operation S603, the battery diagnosis method according to an embodiment may include an operation of identifying, based on a warranty SOH of a battery including the plurality of battery racks and an accuracy of the warranty SOH, a plurality of sections according to the SOH of the battery for expressing the SOH of the battery.

For example, the plurality of sections may include a first section including the largest representative value among representative values respectively included in the plurality of sections. For example, the plurality of sections may include a second section including the smallest representative value among representative values respectively included in the plurality of sections.

For example, the battery diagnosis method may include an operation of dividing a third section into at least one sub-section based on at least one of the minimum SOH, the maximum SOH, a weight, and any combination thereof.

For example, the plurality of sections may be divided into an odd number of sections.

For example, the battery diagnosis method may include an operation of acquiring the weight based on at least one of the warranty SOH, the accuracy thereof, and any combination thereof.

For example, the warranty SOH may include the smallest usable SOH of the battery.

In operation S605, the battery diagnosis method according to an embodiment may include an operation of acquiring, based on the fact that the minimum SOH is included in a specific section among the plurality of sections, the SOH of the battery using at least one of the minimum SOH, the maximum SOH, and any combination thereof.

According to the embodiment, the battery diagnosis method may include an operation of expressing the acquired SOH of the battery.

For example, the battery diagnosis method may include an operation of acquiring the SOH of the battery using the maximum SOH based on the fact that the minimum SOH is included in a first section including the largest representative value among representative values respectively included in the plurality of sections among the plurality of sections.

For example, the battery diagnosis method may include an operation of acquiring the SOH of the battery using the minimum SOH based on the fact that the minimum SOH is included in a second section including the smallest representative value among the representative values respectively included the plurality of sections among the plurality of sections.

For example, the battery diagnosis method may include an operation of acquiring the SOH of the battery using at least one of the minimum SOH, the maximum SOH, a weight, and any combination thereof, based on the fact that the minimum SOH is included in the third section different from both the first section and the second section. For example, the battery diagnosis method may include an operation of acquiring the SOH of the battery using at least one of the minimum SOH, the maximum SOH, a weight, and any combination thereof, the fact of being included in the third section different from both the first section and the second section.

As described above, the battery diagnosis method according to an embodiment may include an operation of acquiring the SOH of the battery according to a section in which the minimum SOH corresponding to the smallest value among the rack SOHs of the respective elements of the battery racks is included. The battery diagnosis method may accurately acquire the SOH of the battery by acquiring the SOH of the battery using the process described above.

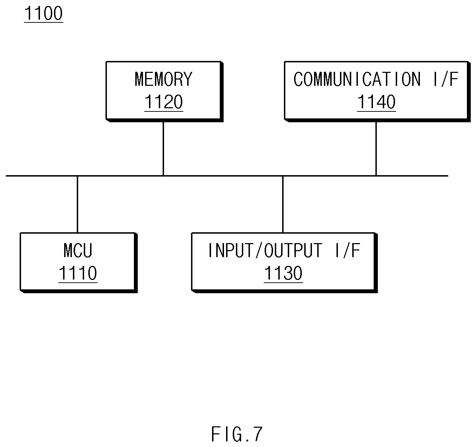

FIG. 7 is a block diagram illustrating a hardware configuration of a computing system that performs a battery diagnosis method, in a battery diagnosis device and the battery diagnosis method according to an embodiment of this document.

Referring to FIG. 7, a computing system 1100 according to an embodiment disclosed in this document may include an MCU 1110, a memory 1120, an input/output I/F 1130, and a communication I/F 1140.

The MCU 1110 may be a processor that executes various programs (e.g., battery cell data collection program, graph generation program, data analysis program, data decomposition algorithm, normalization program, and battery cell diagnosis program, etc.) stored in the memory 1220, processes various information including characteristic data of the battery cell, latent variables, etc. through these programs, and performs the functions of the battery diagnosis device 200 shown in FIGS. 1 to 6 described above.

The memory 1120 may store various programs such as the battery cell data collection program, the graph generation program, the data analysis program, the data decomposition algorithm, the normalization program, and the battery cell diagnosis program.

A plurality of such memories 1120 may be provided as needed. The memory 1120 may be a volatile memory or a nonvolatile memory. The memory 1120 used as the volatile memory may be RAM, DRAM, SRAM, etc. The memory 1120 used as the nonvolatile memory may be ROM, PROM, EAROM, EPROM, EEPROM, flash memory, etc. The examples of the memories 1120 listed above are only examples, but are not limited to these examples.

The input/output I/F 1130 may provide an interface that allows data to be transmitted and received by connecting an input device (not shown) such as a keyboard, mouse, or touch panel and an output device such as a display (not shown) with the MCU 1110.

The communication I/F 1140 is a configuration that can transmit and receive various data with the server, and may be various devices that can support wired or wireless communication. For example, the battery diagnosis device 200 may transmit and receive various information including shape models of battery cells, etc. to and from a separately provided external server through the communication I/F 1140.

In this way, the computer program according to an embodiment disclosed in this document may be implemented as a module that performs, for example, each function shown in FIG. 2, by being recorded in the memory 1120 and processed by the MCU 1110.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above-mentioned disclosure outlines the features of several embodiments so that those skilled in the art may better understand aspects of the present disclosure. Those skilled in the art will understand that the present disclosure may be easily used as a basis for designing or changing different structures to perform the same purpose or achieve the same advantages of embodiments introduced in this document. Furthermore, those skilled in the art will recognize that such equivalent configurations do not depart from the scope of the present disclosure, and that various changes, substitutions, and modifications may be made in this specification without departing from the scope of the present disclosure.

## Claims

1. A battery diagnosis device, comprising:
a memory in which one or more instructions are stored; and
a processor configured to execute the at least one instruction,
wherein the processor is configured to:
identify, based on the fact that rack states of health (SOHs) of the respective elements of a plurality of battery racks are identified, a minimum SOH corresponding to a minimum value among the rack SOHs and a maximum SOH corresponding to a maximum value among the rack SOHs;
identify, based on a warranty SOH of a battery including the plurality of battery racks and an accuracy of the warranty SOH, a plurality of sections according to the SOH of the battery for expressing the SOH of the battery; and
acquire, based on the fact that the minimum SOH is included in a specific section among the plurality of sections, the SOH of the battery using at least one of the minimum SOH, the maximum SOH, and any combination thereof.

2. The battery diagnosis device of claim 1, wherein the processor is configured to acquire the SOH of the battery using the maximum SOH based on the fact that the minimum SOH is included in a first section including a largest representative value among representative values respectively included in the plurality of sections among the plurality of sections.

3. The battery diagnosis device of claim 1, wherein the processor is configured to acquire the SOH of the battery using the minimum SOH based on the fact that the minimum SOH is included in a second section including a smallest representative value among representative values respectively included in the plurality of sections among the plurality of sections.

4. The battery diagnosis device of claim 1, wherein the plurality of sections include a first section including a largest representative value among representative values respectively included in the plurality of sections, and a second section including a smallest representative value among the representative values, and
the processor is configured to acquire the SOH of the battery using at least one of the minimum SOH, the maximum SOH, a weight, and any combination thereof, based on the fact that the minimum SOH is included in a third section different from both the first section and the second section.

5. The battery diagnosis device of claim 4, wherein the processor is configured to divide the third section into at least one sub-section based on at least one of the minimum SOH, the maximum SOH, the weight, and any combination thereof.

6. The battery diagnosis device of claim 4, wherein the processor is configured to acquire the weight based on at least one of the warranty SOH, the accuracy, and any combination thereof.

7. The battery diagnosis device of claim 1, wherein the plurality of sections are divided into an odd number of sections.

8. The battery diagnosis device of claim 1, wherein the warranty SOH includes a smallest usable SOH of the battery.

9. A battery diagnosis method comprising:
an operation of identifying, by a processor, based on the fact that rack states of health (SOHs) of the respective elements of a plurality of battery racks are identified, a minimum SOH corresponding to a minimum value among the rack SOHs and a maximum SOH corresponding to a maximum value among the rack SOHs;
an operation of identifying, by the processor, based on a warranty SOH of a battery including the plurality of battery racks and an accuracy of the warranty SOH, a plurality of sections according to the SOH of the battery for expressing the SOH of the battery; and
an operation of acquiring, by the processor, based on the fact that the minimum SOH is included in a specific section among the plurality of sections, the SOH of the battery using at least one of the minimum SOH, the maximum SOH, and any combination thereof.

10. The battery diagnosis method of claim 9, wherein the battery diagnosis method comprises an operation of acquiring, by the processor, the SOH of the battery using the maximum SOH based on the fact that the minimum SOH is included in a first section including a largest representative value among representative values respectively included in the plurality of sections among the plurality of sections.

11. The battery diagnosis method of claim 9, wherein the battery diagnosis method comprises an operation of acquiring, by the processor, the SOH of the battery using the minimum SOH based on the fact that the minimum SOH is included in a second section including a smallest representative value among representative values respectively included in the plurality of sections among the plurality of sections.

12. The battery diagnosis method of claim 9, wherein the plurality of sections include a first section including a largest representative value among representative values respectively included in the plurality of sections, and a second section including a smallest representative value among the representative values, and
the battery diagnosis method comprises an operation of acquiring, by the processor, the SOH of the battery using at least one of the minimum SOH, the maximum SOH, a weight, and any combination thereof, based on the fact that the minimum SOH is included in a third section different from both the first section and the second section.

13. The battery diagnosis method of claim 12, wherein the battery diagnosis method comprises an operation of dividing, by the processor, the third section into at least one sub-section based on at least one of the minimum SOH, the maximum SOH, the weight, and any combination thereof.

14. The battery diagnosis method of claim 12, wherein the battery diagnosis method comprises an operation of acquiring, by the processor, the weight based on at least one of the warranty SOH, the accuracy, and any combination thereof.

15. The battery diagnosis method of claim 9, wherein the plurality of sections are divided into an odd number of sections.
